# EUROPEAN PATENT APPLICATION

(11) **EP 0 684 671 A1**
(43) Date of publication of application: **29.11.1995**
(21) Application number: 95401022.9
(22) Date of filing: 03.05.1995
(51) Int. Cl.: H01S 3/025, H01L 23/31, H01L 21/306

(54) **Method for the preparation and passivation of the end mirrors of a high emissive power semiconductor laser and related laser device**

(30) Priority: 05.05.1994 IT MI940859
(71) Applicant: ALCATEL N.V., NL-2288 BH Rijswijk (NL)
(72) Inventor: Del Giudice, Massimo, I-24022 Alzano Lombardo (BG) (IT); Pellegrino, Sergio, I-10100 Torino (IT); Vidimari, Fabio, I-20131 Milano (IT); Re, Michele Giovanni, I-20081 Abbiategrasso (MI) (IT)
(74) Representative: Sciaux, Edmond

(57) **Abstract**

The present invention relates to a process for the treatment of the facets of a semiconductor laser, capable of inhibiting their degradation during the high power operation and to the relative laser device.

The invention provides for a process to be carried out in high vacuum condition, capable of removing contaminants and the products of reaction between the atmosphere and the constituents of the semiconductor laser.

At the same time a process of hydrogen diffusion leading to passivation (inactivation) of deep electron energy levels, responsible for various undesired processes of non-radiative recombination, is carried out.

Moreover, a protective dielectric layer capable of preventing the contact between the semiconductor surface and the atmosphere is applied.

## Description

### Background of the invention

The present invention relates to a method for the treatment of semiconductor laser facets, capable of preventing their degradation during operation in high power condition, and to the related laser device.

In these years, high emissive power lasers have gained important fields of application. At present they are used, e.g., in optical recording systems, in laser printers, in optical communication systems.

One of the factors that greatly limit the emissive power in semiconductor laser devices having an emission wavelength less than about one micrometer (thus excluding the Indium phosphide-based emitters, that seem to be free from these problems) is the so-called catastrophic degradation of the mirrors.

This phenomenon looks like a localized melting of the laser mirrors, practically nullifying the power emitted by the device. It is a phenomenon which does not show, on a time scale common to the life of the devices, gradual degradation phenomena associable therewith, but, on the contrary, it has all the features of an autocatalysing process that is used up on a microseconds time scale.

Even if the inmost mechanism is still partially obscure, the associated phenomena have been largely investigated during last years. For instance, in the article by A. Moser titled "Thermodynamics of facet damage in cleaved AlGaAs lasers" published on Applied Physics Letters vol. 59, year 1991, from page 522 on, an empirical formalism is proposed for the estimate of the average life of devices based on AlGaAs alloys, whose main mechanism of failure is the catastrophic degradation of the mirrors.

The degradation manner is shared by devices based on alloys that do not contain Aluminum, as emphasized in the article by D. Sala et al, titled "Analysis of catastrophic optical damage for AlGaAs/InGaAs and InGaP/InGaAs strained quantum well lasers" presented during the ESREF 93 Conference, which took place in Bordeaux on October 4-7, 1993.

This phenomenon is predominant at high emissive powers, while at low powers the average life of these devices can be higher than 10⁵ hours, as well illustrated in the article by M. Okayasu et al, titled "Estimation of the reliability of 0.98 µm InGaAs strained quantum well lasers" published on Journal of Applied Physics vol. 72, 1992 from page 2119 on.

### Degradation mechanism

In the specialized literature full agreement is found in relation to the succession of events leading to the catastrophic degradation of the mirrors.

The phenomenon looks like a localized melting of the laser facets resulting in the self-absorption of the radiation emitted by the device itself and promoted by a high non-radiative recombination velocity.

The high surface recombination velocity at the interface between the semiconductor and the air leads to an increase of temperature in the mirror area with respect to the inner zones of the device. This localized heating causes a local reduction of the energy gap in the mirror area with respect to the inner zones of the device; hence the absorption coefficient can increase remarkably thus resulting, in turn, in the production of more heat. It is clear how this positive feedback mechanism may lead quickly to the localized melting of the facets.

### Description of the Prior Art

On the basis of this explanatory model the specialized literature reports various possible solutions to the problem.

For instance, in the article by Y. Shima et al, titled "Effects of facet coatings on the degradation characteristics of GaAs/GaAlAs lasers", published on Applied Physics Letters vol. 31, 1977, from page 625 on, there is illustrated the protective effect of dielectric coatings on the reliability of the devices. This method, however, is not sufficient to completely eliminate the mirror catastrophic degradation phenomenon, as well explained in the above mentioned article by A. Moser.

Another proposed solution is described in the article by T. Shibutani et al, titled "A novel high power laser structure with current-blocked regions near cavity facets" published on IEEE Journal of Quantum Electronics Vol. QE-23, 1987, from page 760 on, where the use of regions capable of inhibiting the current flow in the vicinity of the laser facets is proposed, and at the same time, the dimensions of the active layer in the same area are reduced in order to suppress the local temperature increase, responsible of the catastrophic degradation of the mirrors. The manufacturing process of these devices is particularly complicated, since it requires two epitaxial growths on non-planar substrates, it can be carried out only through epitaxial deposition techniques with great anisotropy in the rate of growth (such as the liquid phase deposition) and, moreover, sufficient data supporting the asserted efficacy of the method, are not given in the article mentioned above.

### Summary of the invention

It is an object of the invention to provide a method for the passivation of the facets of a semiconductor laser which allows the elimination of the catastrophic degradation of the laser mirrors, thus permitting the use of these devices at high emissive powers. This object is achieved through the application of the method a detailed description of which is given hereinbelow and which can be extended to laser devices formed by materials different from those indicated by way of an example in the flow of the present process.

Characteristics of devices, to which the method of the invention has been applied, are then described as compared with functionally similar devices which have not been subjected to any treatment.

### Detailed description

The passivation process is applied on laser structures, whose manufacturing process is shortly described hereinafter.

A multilayer structure composed of a substrate of, e.g., Gallium Arsenide (GaAs), on which a sequence of epitaxial layers is deposited through techniques such as the Metal-Organic Chemical Vapour Deposition (MOCVD) or the Molecular Beam Epitaxy (MBE).

Such a structure comprises:
i) n-type GaAs buffer,
ii) lower n-type AlGaAs cladding,
iii) optical guide composed of AlGaAs with an aluminum content lower than the one of layers ii) and vi),
iv) InGaAs active layer,
v) optical guide composed of AlGaAs with an aluminum content lower than the one of layers ii) and vi),
vi) upper p-type AlGaAs cladding,
vii) p-type GaAs layer for the electrical contact of the structure.

The working of the epitaxial wafers thus obtained provides for a sequence of technological steps designed to form the guiding structure, to realize the electrical contacting, to arrive at the cleavage of the bar from which the real devices are obtained.

In order to realize the waveguide, for instance the Ridge Waveguide (RW), non-selective etchings are used, which allow the realization of the guide in a unique etching process

There are two known possible solutions:
a) one used solution belongs to the category of mixtures H₂SO₄ : H₂O₂ : H₂O fully described and characterized in the literature;
b) a further possibility of realizing this type of structure provides for Reactive Ion Etching (RIE) plasma process. In this case the planar structure, suitably masked with Ni in order to obtain the confined guide, is placed on the cathode inside a vacuum chamber.

The process gases, for instance a combination of CH₄/H₂/Ar, are introduced successively and a discharge at 13.56 MHz is triggered.

The semiconductor surface is then in contact with reactive ions etching it both physically (by bombardment) and chemically, while the etching dept is continuously controlled in-situ through a laser interferometer.

Lastly, laser bars are separated from the epitaxial wafer by cutting and cleavage for forming the mirrors of the device.

The passivation process described hereinafter is applied on the laser bars thus obtained.

The bars, whose cleft facets have been exposed to air since the instant of separation and therefore show a remarkable degree of oxidation, are introduced into an rf (13.56 MHz) reactor of the type parallel-plates Plasma Enhanced Chemical Vapour Deposition (PECVD) with a base vacuum P_{base} < 10⁻⁵ bars and operating at a pressure varying between 0.1 and 0.5 bars.

The first step of the process consists in the removal of the oxides of the elements of group V, present on the laser mirror, through the creation of hydrogen plasma reducing atmosphere.

The oxygen bonded, e.g., to arsenic or phosphorus, in the presence of a highly reducing atmosphere, reacts with the elements of group III thus forming more stable oxides such as GaO₍ₓ₎, AlO₍ₓ₎ and InO₍ₓ₎. At the same time there is the formulation of volatile hydrides of the elements of group V, such as AsH₃ and PH₃, which are removed from the surface.

Removal of contaminants and oxides, at this stage of the process, is already enough to reduce the degradation of the laser devices to which this first part of the treatent, which is the subject of the present invention, is applied.

During the removal of oxides, contaminants and elementary species of group V a diffusion of elementary hydrogen inside the semiconductor occurs.

It is known, e.g. from the article by A.Y. Pakhomov et al, titled "Hydrogen passivation: relevance to semi-insulating III-V materials" presented at 6th Conference on Semi-insulating materials, Toronto, Canada, 1990, that hydrogen inactivates the deep electron energy levels in III-V materials.

Hydrogen passivation keeps also at high temperatures up to about 600°C, thus stably reducing the processes of non-radiative recombination associated with these electron energy levels. A tridimensional diffuse layer with low capacity of heat generation is then obtained.

Surprisingly, this passivation method has never been applied to semiconductor laser devices, and this knowledge remained confined to the basic studies on solid state physics.

In a second step, an ammonia plasma is produced in the PECVD reactor in order to remove the remaining oxides of group IlI thus restoring the laser facet to a compositional stoichiometry condition and free from contaminants.

These processes occur at a temperature T = 250 to 350 (300) °C, at a pressure P = 0.1 to 0.5 (0.35) bars, at an rf power of 5 to 20 (7) watts for a duration t = 10 to 1000 (500) seconds, where the preferred values are indicated in brackets.

The complete removal of native oxides and of elementary As or P clusters, leads to a reduction in the antisite defects associated with As or P with a drastic reduction of the surface recombination velocity and the local heating associable therewith is then significantly reduced.

The surface, prepared as explained herein, keeps a certain degree of reactivity toward the external environment. A protective dielectric layer, such as Si N(x), is then deposited in order to isolate the surface of the laser mirror from the external environment.

Such deposition process occurs straight after the steps described previously in such a way that the continuity of the process is not interrupted and a highly reducing atmosphere is maintained.

The encapsulating layer is deposited in a minimum stress condition with respect to the supporting semiconductor, through a gradual adjusting of its nitrogen content, and by varying the hydrogen content present in the film.

The final step of the process provides for a thermal cycle to stabilize the passivated structure, which is carried out in an H₂/N₂ atmosphere at a temperature T = 300 to 450 (400) °C for a duration of t = 5 to 60 (30) seconds, where the preferred values are those indicated in brackets.

This process allows a further settling of the structure thus reducing further the stress thereof.

Alternatively, the process described above can be carried out in an Electron Cyclotron Resonance (ECR) reactor operating in a higher base-vacuum condition, P_{base} < 10⁻¹¹ bars with a reduction of the damaging associated with the physical component of the process, or of the ion bombardment of the surface.

It can be applied, as well, to semiconductor laser structures formed by different materials such as, e.g., InGaAsP alloys both for the direct substitution of the alloys containing Aluminum and for the realization of laser structures emitting in the visible spectrum region through the use of structures based on alloys, e.g., of type InGaAlP.

The encapsulating layer can further be formed by AlN(x), deposited in a minimum stress condition, through a gradual adjusting of its nitrogen content, and by varying the hydrogen content present in the film.

The deposition of dielectric layers having high/low reflex optical functions is carried out on the laser bars obtained at the end of the process.

These depositions are indispensable both for further protecting the laser mirrors from the oxidation and for using at best the power emitted from the device which, being intrinsically symmetrical, would irradiate it equally from its end facets.

For the antireflex layers generally individual λ/4 alumina layers will be deposited, where for the high reflex an appropriate number (2-3) of alumina and silicon bi-strates is used.

### Experimental evidences

The presence of oxides or contaminations on the end mirrors of the laser results, as fully described previously, in an increase in the surface recombination rate.

The photoluminescence (PL) diagnostic technique is capable of detecting the state of the surface, the intensity of the PL peaks being inversely proportional to the surface recombination rate.

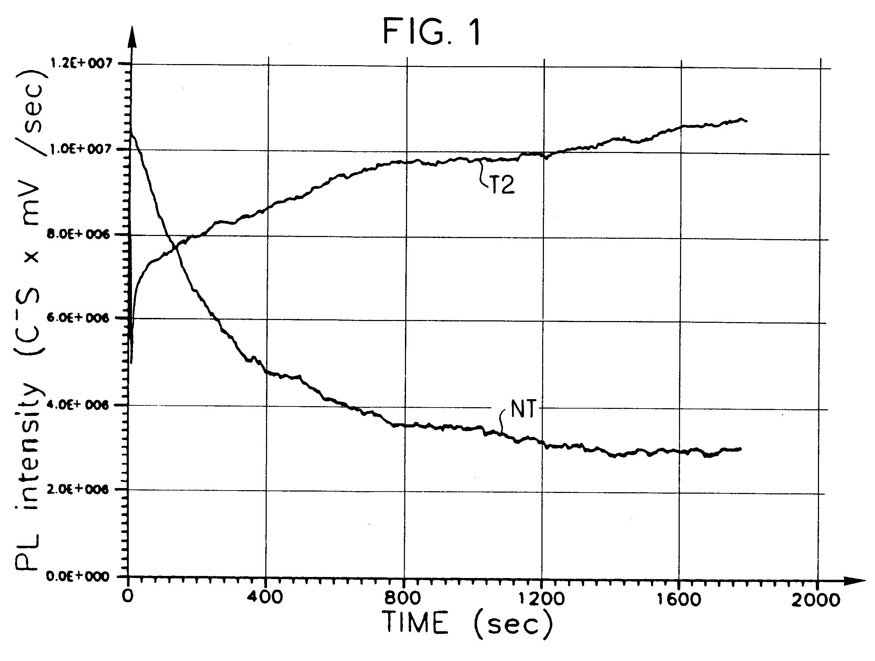

This technique further allows the measurement of the time evolution of the PL signal, as the monitoring of the eventual surface degradation phenomena. Fig. 1 illustrates the shape of the PL signal in case of samples, untreated (NT) and treated (T2) in accordance with the method of the present invention.

It can be noted that the PL signal coming from NT samples decreases with time thus indicating a progressive degradation of the surface. On the contrary treated samples T2 not only appear free from degradation, but highlight a progressive stabilization of the surface with a consequent increase in the PL signal.

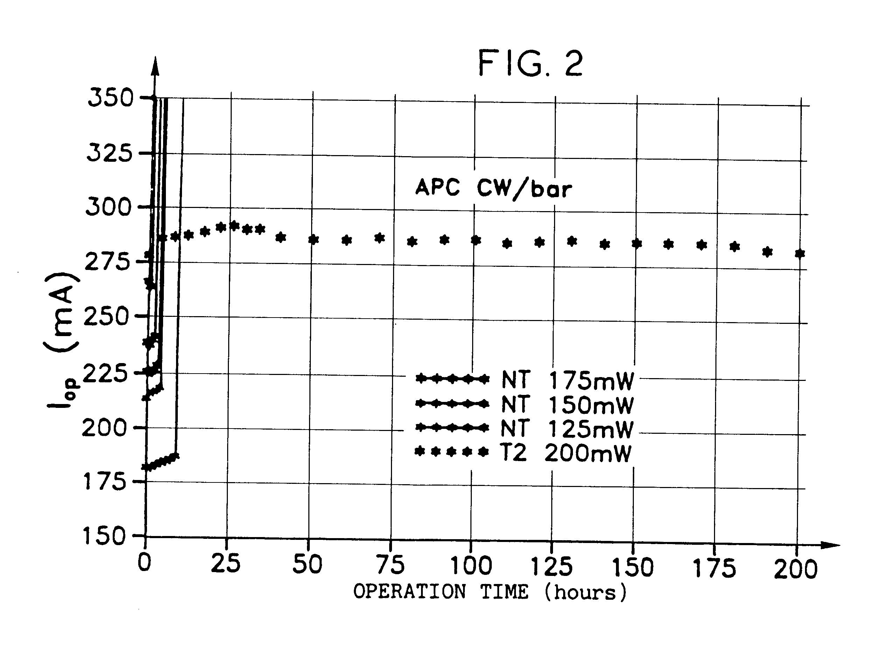

The behaviour of T2 devices in Fig. 2 is compared with the one of NT devices; the untreated devices after a short period of operation fall into the catastrophic degradation of the mirrors. On the contrary, devices T2 operate without exhibiting perceptible degradation during the duration of the experiment.

## Claims

1. Method of preparing and passivating the end mirrors of a semiconductor laser, characterized by comprising the step of treating said laser mirrors in a highly reducing atmosphere to eliminate the native oxides and the surface contaminants.

2. Method in accordance with claim 1, characterized in that said reducing atmosphere comprises atomic hydrogen.

3. Method in accordance with claim 2, characterized in that said reducing atmosphere is generated by hydrogen plasma.

4. Method in accordance with claim 2, characterized in that said reducing atmosphere is capable of giving out hydrogen in the area adjacent to said mirrors.

5. Method according to claim 1, characterized in that it further comprises the step of treating the laser mirrors in ammonia plasma.

6. Method according to claim 2 or 3, characterized by using a PECVD reactor.

7. Method in accordance with claim 6, characterized in that said reactor acts within the temperature range of 250 to 350°C, within the pressure range of 0.1 to 0.5 bars, within the RF power range of 5 to 20 W and for a duration comprised between 10 and 1000 seconds.

8. Method in accordance with claim 1, characterized by further comprising the step of physically coating said mirrors.

9. Method in accordance with claim 8, characterized in that said coating is constituted by an SiN(x) layer.

10. Method according to claim 8, characterized in that said coating is constituted by an AlN(x) layer.

11. Method according to claim 9 or 10, characterized in that said coating is deposited in a minimum stress condition of the materials, through the creation of a compositional gradient of Nitrogen and through the variation of the hydrogen content of said layer.

12. Heterojunction semiconductor laser device, characterized in that at the surface of the end mirrors it is free from native oxides and from contaminants.

13. Heterojunction semiconductor laser device according to claim 12, characterized in that in the area adjacent to said end mirrors it shows a layer comprising hydrogen.

14. Heterojunction semiconductor laser device according to claim 12 or 13, characterized in that it has a protective coating deposited on the end mirrors.
